Europäisches Patentamt

(19) European Patent Office

Office européen des brevets

(11) Numéro de publication: **0 227 499 B1**

(12) **FASCICULE DE BREVET EUROPEEN**

(45) Date de publication du fascicule du brevet:
18.07.90

(51) Int. Cl.⁵: **C30B 15/00**, C30B 29/22, C09K 11/78

(21) Numéro de dépôt: 86402282.7

(22) Date de dépôt: 14.10.86

(54) **Aluminates mixtes de lanthane-magnesium, leur procédé de fabrication et lasers utilisant ces aluminates.**

(30) Priorité: 21.10.85 FR 8515579

(43) Date de publication de la demande:
01.07.87 Bulletin 87/27

(45) Mention de la délivrance du brevet:
18.07.90 Bulletin 90/29

(84) Etats contractants désignés:
DE GB

(56) Documents cités:
FR-A-2 442 264

JOURNAL OF APPLIED PHYSICS,
vol. 52, no. 11, novembre 1981, pages 6864-6869, American Institute of Physics, New York, US; A. KAHN et al.: "Preparation, structure, optical, and magnetic properties of lanthanide aluminate single crystals (LnMA111O19) r" 000

(73) Titulaire: COMMISSARIAT A L'ENERGIE ATOMIQUE, 29-31, rue de la Fédération, F-75015 Paris(FR)
Titulaire: CENTRE NATIONAL DE LA RECHERCHE SCIENTIFIQUE (CNRS), 15, Quai Anatole France, F-75700 Paris Cedex 07(FR)

(72) Inventeur: Aubert, Jean-Jacques, 6, Résidence Beauséjour Le Fontanil, F-38120 Saint Egreve(FR)
Inventeur: Couchaud, Maurice, 12, rue de Pacalaire, F-38170 Seyssinet-Pariset(FR)
Inventeur: Lejus, Anne-Marie, 70, Avenue Aristide Briand, F-92120 Montrouge(FR)
Inventeur: Vivien, Daniel, 6 Bis, rue de Kronstadt, F-92380 Garches(FR)

(74) Mandataire: Mongrédien, André et al, c/o BREVATOME 25, rue de Ponthieu, F-75008 Paris(FR)

## Description

La présente invention a pour objet des aluminates mixtes de lanthane et de magnésium, obtenus sous forme de monocristaux, ainsi que leur procédé de fabrication.

Ces aluminates mixtes trouvent des applications dans le domaine des micro-lasers pour l'optique intégrée ou des télécommunications par fibres optiques et dans le domaine des lasers de puissance continus ou pulsés, émettant principalement dans l'infrarouge à des longueurs d'onde de 1,054 $\mu$m et 1,08 $\mu$m, avec un certain degré d'accord en longueurs d'onde ainsi qu'au voisinage de 1,3 $\mu$m. Ces lasers de puissance émettant dans l'infrarouge permettent notamment d'effectuer des traitements de matériaux (soudure, perçage, marquage, traitement de surfaces), des réactions photo-chimiques ainsi que la fusion thermonucléaire contrôlée.

On connaît actuellement des aluminates mixtes de lanthane et de magnésium de formule chimique $La_{1-x}Nd_xMgAl_{11}O_{19}$ dans laquelle x est un nombre positif inférieur ou égal à 1. Comme aluminates, on peut en particulier citer celui répondant à la formule $La_{0,9}Nd_{0,1}MgAl_{11}O_{19}$. De tels aluminates mixtes sont notamment décrits dans le document EP-A-0 043 776.

L'aluminate mixte pour lequel x égale 0,1 est particulièrement bien adapté comme émetteur laser car il présente des propriétés optiques comparables à celles que possèdent le grenat d'yttrium et d'aluminium de formule $Y_3Al_5O_{12}$, connu sous le nom de YAG, dans lequel 1% des ions yttrium sont remplacés par des ions néodymes et l'ultraphosphate de néodyme de formule $NdP_5O_{14}$, utilisés couramment comme émetteurs pour lasers travaillant dans l'infrarouge.

Les aluminates mixtes ci-dessus et notamment celui de composition $La_{1-x}Nd_xMgAl_{11}O_{19}$ peuvent être préparés sous forme de monocristaux par la méthode de Verneuil, la méthode de Czochralski ou toute autre méthode de cristallogénèse à partir du bain fondu de l'aluminate, afin de présenter l'effet laser.

Malheureusement, ces aluminates mixtes ne présentent pas de fusion dite congruente, c'est-à-dire que le monocristal ne possède pas la même composition que le bain fondu.

En conséquence, la fabrication de monocristaux de ces aluminates, et en particulier par la méthode de Czochralski la plus couramment utilisée, conduit à des cristaux de qualité insuffisante (bulles, défauts) dès qu'il s'agit d'atteindre les grandes dimensions requises par l'industrie des lasers de puissance (barreau de 6,35 mm de diamètre et 100 mm de long).

L'invention a justement pour objet de nouveaux aluminates mixtes de lanthane-magnésium réalisables sous forme de monocristaux de grandes dimensions et par conséquent utilisables dans l'industrie des lasers de puissance.

Selon la caractéristique principale de l'invention, ces aluminates mixtes de lanthane-magnésium se caractérisent en ce qu'ils présentent la formule suivante:

$La_{1-x}Nd_xMg_yAl_{11}O_{18+y}$

dans laquelle x et y représentent des nombres tels que $0 < x \leq 0,2$ et $0,4 < y \leq 0,8$.

Ces aluminates mixtes monophasés présentent une structure cristalline, du type magnétoplombite, à maille hexagonale. Ils possèdent des propriétés mécaniques et thermiques voisines de celles de l'alumine.

Selon l'invention, ces aluminates présentent une fusion dite congruente et les cristaux élaborés par la méthode de Czochralski, la plus couramment utilisée dans l'industrie, sont de bonne qualité. Il est alors possible de préparer les monocristaux de grandes dimensions demandés par l'industrie des lasers de puissance.

Par ailleurs, ces aluminates mixtes présentant pendant la croissance d'un monocristal une absence de ségrégation des constituants permettent d'augmenter la vitesse de tirage du monocristal, par rapport aux aluminates mixtes connus ; ceci entraîne de ce fait un gain important sur la durée de préparation des monocristaux ainsi que sur la durée de vie des creusets contenant le bain à partir duquel on effectue le tirage.

De façon avantageuse, les aluminates mixtes de l'invention ont une composition telle que y est compris entre 0,4 et 0,7 et de préférence au moins égal à 0,5 et au plus égal 0,55. En particulier, on peut citer le composé de formule $La_{0,9}Nd_{0,1}Mg_{0,52}Al_{11}O_{18,52}$.

Lorsque x est voisin de 0,1, les aluminates mixtes de l'invention peuvent être utilisés comme émetteurs lasers de puissance fonctionnant en continu.

De même, lorsque x est voisin de 0,2, les aluminates mixtes de l'invention peuvent être utilisés comme émetteurs lasers de puissance fonctionnant en impulsion.

Les aluminates mixtes de l'invention peuvent être obtenus à partir d'un premier procédé de fabrication se caractérisant en ce que l'on mélange intimement dans des proportions convenables les poudres des oxydes $La_2O_3$, $Nd_2O_3$, $MgO$ et $Al_2O_3$, on calcine puis on fond le mélange obtenu et on traite le mélange fondu afin d'obtenir, par solidification du mélange, un monocristal.

Ce procédé présente l'avantage d'une mise en oeuvre simple et peu onéreuse.

En général, la calcination est réalisée entre 1500 et 1600°C, elle permet d'éliminer toute trace d'eau. Après cette calcination, le mélange de poudres est broyé.

Pour faciliter l'homogénéisation du mélange, on choisit des poudres présentant une granulométrie comprise entre 1 et 10 $\mu$m.

Les aluminates mixtes de l'invention peuvent aussi être obtenus à partir d'un second procédé de fabrication se caractérisant en ce que l'on coprécipite les hydroxydes des ions $La^{3+}$, $Nd^{3+}$, $Mg^{2+}$ et $Al^{3+}$ dissous sous forme de sels dans un solvant aqueux ou non, dans des proportions convenables, on calcine puis on fond le coprécipité obtenu et on traite le coprécipité fondu de façon à obtenir, par solidification du coprécipité, un monocristal.

Ce deuxième procédé, de mise en oeuvre aussi aisé que le premier, présente l'intérêt de donner un mélange très homogène.

Pour effectuer la coprécipitation des hydroxydes on peut par exemple préparer une solution formée par du $Nd_2O_3$ et du $La_2O_3$ et du MgO dissous dans de l'acide nitrique dilué afin d'obtenir les nitrates correspondants. Une suspension d'$Al_2O_3$ est additionnée à la solution. On effectue ensuite la coprécipitation des hydroxydes notamment avec de l'ammoniac.

La calcination dans ce second procédé est réalisée vers 1200 C. Elle permet notamment l'élimination du nitrate d'ammonium ($NH_4NO_3$) formé lors de l'addition de l'ammoniac. Après cette calcination, le coprécipité est broyé.

Pour former un monocristal, à partir du bain fondu de même composition que celle du monocristal souhaité, on peut utiliser toutes les méthodes de cristallogénèse connues utilisant un bain fondu telles que la méthode de Verneuil, de zone fondue, de Bridgmann ou de Czochralski.

Les monocristaux obtenus selon les procédés de l'invention présentent un effet laser dans le domaine des infrarouges. Cet effet laser est d'autant plus important que la pureté des monocristaux obtenus est élevée.

Pour obtenir un rendement aussi élevé que possible, les matières premières utilisées devront être d'une grande pureté. En particulier, les poudres de départ devront présenter une pureté supérieure 99,98%.

D'autres caractéristiques et avantages de l'invention ressortiront mieux de la description qui va suivre, donnée à titre purement illustratif et nullement limitatif, en référence aux figures annexées dans lesquelles :

- la figure 1 représente schématiquement un laser continu utilisant un monocristal d'aluminate selon l'invention, et
- la figure 2 représente schématiquement un laser pulsé de puissance utilisant un monocristal d'aluminate selon l'invention.

On décrit ci-après la fabrication de monocristaux, par la méthode de Czochralski dans un creuset en iridium, d'aluminates mixtes selon l'invention, répondant aux formules données dans la partie gauche du tableau ci-après. Ces aluminates sont fabriqués en phase sèche par mélange de poudres des oxydes de $La_2O_3$, $Nd_2O_3$, MgO et $Al_2O_3$ ; les quantités de poudres utilisées sont données dans la partie gauche du tableau.

Les quantités relatives de poudres sont déterminées par pesées dans un flacon en polyéthylène de 2 litres.

Comme matière première, on peut prendre la poudre de $La_2O_3$ et de $Nd_2O_3$ de chez RHONE-POULENC respectivement de 99,999% et de 99,99% de pureté, la poudre de MgO de chez JMC commercialisée sous le nom Gd1 de 99,999% de pureté et la poudre de $Al_2O_3$ de chez CRICERAM commercialisée sous le nom de "exal α" de 99,98% de pureté.

Les oxydes de lanthane et de néodyme étant très hydroscopiques, il est tout d'abord nécessaire de les calciner, avant de les mélanger à l'alumine. Cette calcination se fait dans un creuset en alumine pendant 16 heures, à une température de 1100°C.

Aux oxydes de La et Nd calcinés dans le creuset en alumine, on ajoute les poudres de magnésie et d'alumine. On effectue ensuite une homogénéisation du mélange de poudres par brassage pendant 24 h. Ce mélange est ensuite compacté par pressage isostatique dans une enveloppe de latex de 70 mm de diamètre sous une pression de 0,2 GPa (2 kilobars). On effectue ensuite, dans le creuset en alumine un recuit pendant 20 heures à 1550°C.

La poudre d'aluminate mixte ainsi obtenue est ensuite placée dans un creuset en iridium de 60 mm de diamètre et 60 mm de haut, et est portée, à l'abri de l'oxygène de l'air, à une température de fusion égale à 1810°C afin de former un bain d'aluminate fondu.

Un germe monocristallin de même composition que le bain fondu, taillé parallèlement soit à la direction cristallographique dite _c_, soit à la direction dite _a_ de la maille hexagonale de l'aluminate, est alors amené au contact du bain liquide et remonté lentement vers le haut tout en étant animé d'un mouvement de rotation sur lui-même. La vitesse de tirage, supérieure à celle des aluminates connus, est de 1 mm/h et la vitesse de rotation est de 30 t/min. Le monocristal est ainsi formé progressivement au bout du germe selon la direction imposée par celui-ci.

Avec cette technique de tirage, on a obtenu des barreaux d'aluminate de 25 mm de diamètre et de 100 mm de long.

### EXAMPLES DE MONOCRISTAUX OBTENUS PAR TIRAGE CZOCHRALSKI

| Quantités de poudre en g | | | | Cristal obtenu |
|---|---|---|---|---|
| $La_2O_3$ | $Nd_2O_3$ | MgO | $Al_2O_3$ | |
| 97,75 | 11,22 | 13,97 | 373,86 | $La_{0,9}Nd_{0,1}Mg_{0,52}Al_{11}O_{18,52}$ |
| 97,75 | 11,22 | 16,20 | 373,86 | $La_{0,9}Nd_{0,1}Mg_{0,6}Al_{11}O_{18,6}$ |
| 97,75 | 11,22 | 21,60 | 373,86 | $La_{0,9}Nd_{0,1}Mg_{0,8}Al_{11}O_{18,8}$ |
| 97,75 | 11,22 | 12,15 | 373,86 | $La_{0,9}Nd_{0,1}Mg_{0,45}Al_{11}O_{18,45}$ |
| 92,32 | 16,83 | 13,43 | 373,86 | $La_{0,85}Nd_{0,15}Mg_{0,5}Al_{11}O_{18,5}$ |
| 92,32 | 16,83 | 18,81 | 373,86 | $La_{0,85}Nd_{0,15}Mg_{0,7}Al_{11}O_{18,7}$ |

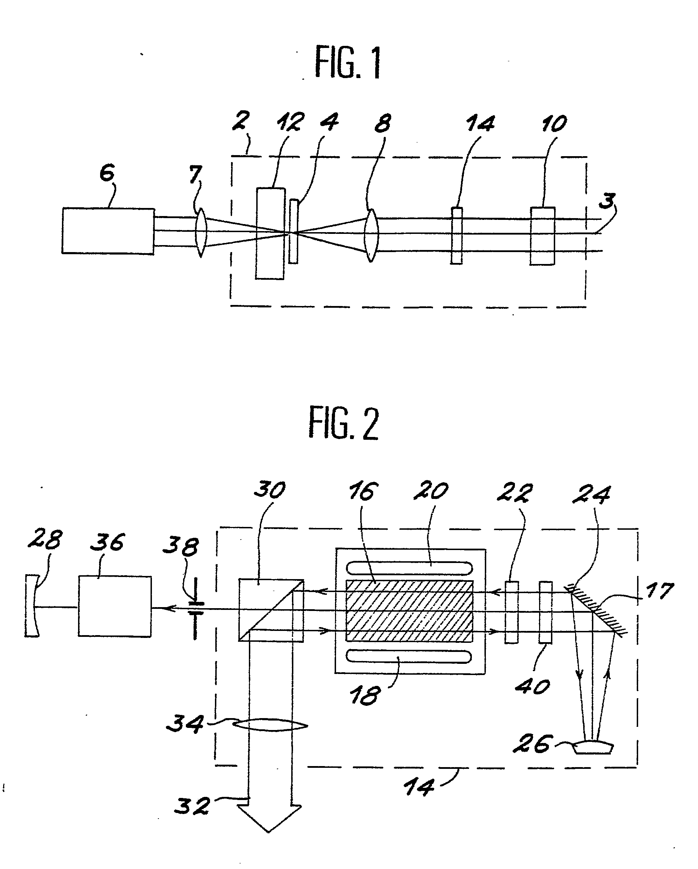

Sur la figure 1, on a représenté schématiquement un laser de puissance continu émettant dans l'infrarouge, utilisant un monocristal d'aluminate selon l'invention. Les longueurs d'onde d'émission sont 1054, 1083 et 1320 nm.

Ce laser comprend une cavité laser 2 contenant un barreau 4 d'aluminate selon l'invention disposé perpendiculairement à l'axe longitudinal 3 du laser. Ce barreau d'aluminate 4 présente par exemple la formule

$La_{0,9}Nd_{0,1}Mg_{0,52}Al_{11}O_{18,52}$

Une source de lumière monochromatique 6, telle qu'un laser à argon ou krypton ionisé, permet d'irradier le barreau d'aluminate 4, via une lentille de convergence 7, afin d'assurer le pompage optique du barreau 4.

La cavité laser 2 se compose aussi d'une lentille convergente 8 transformant la lumière émise par le barreau d'aluminate 4 en un faisceau de lumière paralléle qui est envoyé sur un miroir de sortie 10.

Aprés réflexion sur ce miroir 10, le faisceau lumineux traverse à nouveau la lentille convergente 8 et le milieu amplificateur ou barreau d'aluminate 4. Le faisceau laser amplifié est alors réfléchi par un miroir d'entrée dichroïque 12 à proximité duquel est placé le barreau 4, ce miroir 12 étant transparent à la lumière émise par la source monochromatique 6 et opaque à celle émise par le monocristal d'aluminate 4.

Le faisceau laser suffisamment amplifié dans la cavité 2 est alors envoyé vers l'extérieur du laser, via le miroir 10, qui est partiellement transparent à la lumière émise par le monocristal d'aluminate 4.

L'accordabilité en longueur d'onde peut être obtenue à l'aide d'un systéme de sélection en longueur d'onde 14 intercalé entre la lentille convergente 8 et le miroir de sortie 10 de la cavité laser 2, du type prisme à angle de Brewster ou filtre interférentiel formé de deux lames en matériau biréfringent.

Les aluminates selon l'invention peuvent aussi être utilisés sous forme monocristalline dans un laser de puissance émettant sous forme d'impulsions. A cet effet, on a représenté sur la figure 2, un laser de puissance pulsé, émettant dans l'infrarouge.

Ce laser pulsé comprend une cavité 14 contenant un barreau monocristallin 16 d'un aluminate selon l'invention disposé parallèlement à l'axe longitudinal 17 du laser. Cet aluminate présente par exemple la formule :

$La_{0,8}Nd_{0,2}Mg_yAl_{11}O_{18+y}$ avec $0,4 < y < 0,7$

De part et d'autre du barreau 16, sont disposées des lampes flash au xénon de forte intensité 18 et 20, de forme allongée, orientées aussi selon l'axe 17 du laser. Ces lampes assurent un pompage optique longitudinal du barreau d'aluminate 16.

La cavité laser 14 se compose aussi d'une lame quart d'onde 22 transformant la lumière incidente polarisée linéairement, issue du barreau 16, en une lumière polarisée circulairement. Cette lame 22 est suivie d'un miroir plan 24 et d'un miroir convexe 26 divergent.

Aprés réflexion sur le miroir 26, le faisceau lumineux élargi, adapté et polarisé circulairement, traverse à nouveau la lame quart d'onde 22 produisant ainsi un faisceau polarisé verticalement qui balaye complètement le milieu amplificateur ou barreau 16, en en extrayant le maximum d'énergie lumineuse.

Le faisceau laser amplifié se propageant dans la direction d'un autre miroir 28 hautement réfléchissant concave, est interrompu par un prisme polariseur 30 éjectant le faisceau polarisé verticalement 32 hors de la cavité laser. Une lentille convergente 34 permet l'obtention d'un faisceau de lumière parallèle.

Ce laser pulsé est équipé d'un interrupteur électro-optique 36, plus généralement désigné sous le vocable anglo-saxon de "$Q_1$ switch", disposé entre le miroir concave 38 et le polariseur de sortie 30. Lorsque cet interrupteur est fermé, c'est-à-dire qu'une tension lui est appliquée, le laser ne peut fonctionner. En effet, pendant que l'on "pompe", le milieu amplificateur avec les lampes 18 et 20, le polariseur 30 est transparent aux photons polarisés horizontalement et laisse passer la lumière vers l'interrupteur 36. Celui-ci faisant tourner la direction de polarisation de 90° empêche le polariseur 30 de transmettre cette lumière.

Inversement, lorsqu'on ouvre l'interrupteur électro-optique 36, celui-ci n'altère plus la polarisation horizontale issue du polariseur permettant ainsi à la cavité laser 14 d'amplifier la lumière émise par le barreau 16.

Un diaphragme 38 peut être intercalé entre l'interrupteur et le polariseur pour canaliser la lumière laser.

Pour obtenir un laser pulsé accordable en longueur d'onde, un dispositif de sélection en longueur d'onde 40 tel que décrit ci-dessus doit être intercalé entre la lame 22 et le miroir 24.

Les lasers décrits ci-dessus n'ont bien entendu été donnés qu'à titre illustratif, d'autres types de lasers pouvant être équipés d'un monocristal d'aluminate selon l'invention.

Les monocristaux d'aluminates selon l'invention peuvent être utilisés dans toutes les applications utilisant actuellement un émetteur laser du type YAG. En particulier, ces monocristaux peuvent être utilisés pour des lasers destinés à la découpe ou au marquage de matériau ainsi que pour réaliser des soudures.

La découpe de matériau est assurée en plaçant un aluminate monocristallin dans la cavité d'un laser, tel que décrit précédemment, en orientant puis en focalisant à la surface du matériau la lumière issue du laser afin de porter ce matériau localement à son point de fusion et d'assurer ainsi sa découpe au fur et à mesure qu'il se déplace dans le faisceau laser.

En plus des applications du type YAG, les aluminates selon l'invention présentent des applications qui leur sont propres, liées en particulier à la longueur d'onde d'émission laser principale qui est de 1,054 μm. Cette longueur d'onde peut servir pour le déclenchement de l'effet laser des verres phosphates et fluorophosphates utilisés comme étages amplificateurs dans les systèmes d'étude de la fusion thermonucléaire contrôlée selon la méthode dite du confinement inertiel. Dans ce domaine d'application particulier, l'aluminate selon l'invention concurrence ainsi le fluorure de lithium et d'yttrium de formule LiYF$_4$ dopé par du néodyme, généralement utilisé.

**Revendications**

1. Aluminate mixte de lanthane et de magnésium, caractérisé en ce qu'il présente la formule suivante:

La$_{1-x}$Nd$_x$Mg$_y$Al$_{11}$O$_{18+y}$

dans laquelle x et y représentent des nombres tels que $0 < x \leq 0,2$ et $0,4 < y \leq 0,8$.

2. Aluminate selon la revendicatoin 1, caractérisé en ce que y est compris entre 0,4 et 0,7.

3. Aluminate selon la revendication 1 ou 2, caractérisé en ce que y est tel que $0,5 \leq y \leq 0,55$.

4. Aluminate selon l'une quelconque des revendications 1 à 3, caractérisé en ce que x est égal à 0,1.

5. Aluminate selon la revendication 1, caractérisé en ce qu'il répond à la formule:

La$_{0,9}$Nd$_{0,1}$Mg$_{0,52}$Al$_{11}$O$_{18,52}$

6. Aluminate selon l'une quelconque des revendications 1 à 3, caractérisé en ce que x est égal à 0,2.

7. Procédé de fabrication d'un aluminate mixte monocristallin selon l'une quelconque des revendications 1 à 6, caractérisé en ce que l'on mélange intimement dans des proportions convenables les poudres des oxydes La$_2$O$_3$, Nd$_2$O$_3$, MgO et Al$_2$O$_3$, on calcine puis on fond le mélange obtenu et on traite le mélange fondu afin d'obtenir, par solidification du mélange, un monocristal.

8. Procédé de fabrication d'un aluminate mixte monocristallin selon l'une quelconque des revendications 1 à 6, caractérisé en ce que l'on coprécipite les hydroxydes des ions La$^{3+}$, Nd$^{3+}$, Mg$^{2+}$ et Al$^{3+}$ dissous dans un solvant aqueux ou non dans des proportions convenables, on calcine puis on fond le coprécipité obtenu et on traite le coprécipité fondu de façon à obtenir, par solidification du coprécipité, un monocristal.

9. Laser continu émettant dans l'infrarouge, caractérisé en ce qu'il comprend un monocristal d'aluminate selon la revendication 4 ou 5.

10. Laser pulsé émettant dans l'infrarouge, caractérisé en ce qu'il comprend un monocristal d'un aluminate selon la revendication 6.

**Patentansprüche**

1. Lanthan-Magnesium-Mischaluminat, dadurch gekennzeichnet, daß es die folgende Formel hat:

La$_{1-x}$Nd$_x$Mg$_y$Al$_{11}$O$_{18+y}$

worin x und y solche Zahlen darstellen, daß $0 < x \leq 0,2$ und $0,4 < y \leq 0,8$.

2. Aluminat nach Anspruch 1, dadurch gekennzeichnet, daß y zwischen 0,4 und 0,7 liegt.

3. Aluminat nach Anspruch 1 oder 2, dadurch gekennzeichnet, daß y eine solche Zahl ist, daß $0,5 \leq y \leq 0,55$.

4. Aluminat nach einem der Ansprüche 1 bis 3, dadurch gekennzeichnet, daß x = 0,1.

5. Aluminat nach Anspruch 1, dadurch gekennzeichnet, daß es der Formel entspricht:

La$_{0,9}$Nd$_{0,1}$Mg$_{0,52}$Al$_{11}$O$_{18,52}$

6. Aluminat nach einem der Ansprüche 1 bis 3, dadurch gekennzeichnet, daß x = 0,2.

7. Verfahren zur Herstellung eines monokristallinen Mischaluminats nach einem der Ansprüche 1 bis 6, dadurch gekennzeichnet, daß man in geeigneten Mengenverhältnissen Pulver der Oxide La$_2$O$_3$, Nd$_2$O$_3$, MgO und Al$_2$O$_3$ innig miteinander mischt, die erhaltende Mischung calciniert und dann schmilzt und die geschmolzene Mischung so behandelt, daß man beim Erstarren der Mischung einen Einkristall erhält.

8. Verfahren zur Herstellung eines monokristallinen Mischaluminats nach einem der Ansprüche 1 bis 6, dadurch gekennzeichnet, daß man Hydroxide der Ionen La³⁺, Nd³⁺, Mg²⁺ und Al³⁺, gelöst in einem wäßrigen oder nichtwäßrigen Lösungsmittel, in geeigneten Mengenverhältnisen gemeinsam ausfällt, das erhaltene Copräzipitat calciniert und dann schmilzt und das geschmolzene Copräzipitat so behandelt, daß man durch Erstarrung des Copräzipitats einen Einkristall erhält.

9. Kontinuierlicher Laser, der im Infrarot-Bereich emittiert, dadurch gekennzeichnet, daß er umfaßt einen Einkristall aus einem Aluminat nach Anspruch 4 oder 5.

10. Pulsierender Laser, der im Infrarot-Bereich emittiert, dadurch gekennzeichnet, daß er umfaßt einen Einkristall aus einem Aluminat nach Anspruch 6.

## Claims

1. Mixed aluminate of lanthanum and magnesium, characterized in that it is of general formula:

$$La_{1-x}Nd_xMg_yAl_{11}O_{18+y}$$

in which x and y represent numbers such that $0 < x \leq 0.2$ and $0.4 < y \leq 0.8$.

2. Aluminate according to claim 1, characterized in that y is between 0.4 and 0.7.

3. Aluminate according to claims 1 or 2, characterized in that y is such that $0.5 \leq y \leq 0.55$.

4. Aluminate according to any one of the claims 1 to 3, characterized in that x is equal to 0.1.

5. Aluminate according to claim 1, characterized in that it is in accordance with formula:

$$La_{0.9}Nd_{0.1}Mg_{0.52}Al_{11}O_{18.52}$$

6. Aluminate according to any one of the claims 1 to 3, characterized in that x is equal to 0.2.

7. Process for the production of a mixed monocrystalline aluminate according to any one of the claims 1 to 6, characterized in that powders of oxides $La_2O_3$, $Nd_2O_3$, MgO and $Al_2O_3$ are intimately mixed in appropriate proportions, followed by the calcining and melting of the mixture obtained and the treatment of the molten mixture in order to obtain a monocrystal by the solidification of said mixture.

8. Process for the production of a mixed monocrystalline aluminate according to any one of the claims 1 to 6, characterized in that hydroxides of the ions La³⁺, Nd³⁺, Mg²⁺ and Al³⁺ dissolved in an aqueous or nonaqueous solvent in appropriate proportions are coprecipitated, followed by calcining and melting the coprecipitate obtained and treating the molten coprecipitate so as to obtain a monocrystal by solidifying the coprecipitate.

9. Continuous laser emitting in the infrared, characterized in that it comprises an aluminate monocrystal according to claims 4 or 5.

10. Pulsed laser emitting in the infrared, characterized in that it comprises a monocrystal of an aluminate according to claim 6.

# FIG. 1

# FIG. 2